# EUROPEAN PATENT APPLICATION

(11) **EP 4 836 639 A1**
(43) Date of publication of application: **04.11.2026**
(21) Application number: 24921792.8
(22) Date of filing: 23.12.2024
(51) Int. Cl.: H10F 19/80

(54) **SOLAR CELL MODULE, PHOTOVOLTAIC MODULE, AND ELECTRIC DEVICE**

(30) Priority: 31.01.2024 CN 202420242014 U
(71) Applicant: Contemporary Amperex Technology Co., Limited, Ningde, Fujian 352100 (CN)
(72) Inventor: TU, Bao, Ningde, Fujian 352100 (CN); LIU, Xiao, Ningde, Fujian 352100 (CN); XIE, Qiaowen, Ningde, Fujian 352100 (CN); YANG, Junjie, Ningde, Fujian 352100 (CN); LI, Zhenzhen, Ningde, Fujian 352100 (CN); CHEN, Guodong, Ningde, Fujian 352100 (CN); OUYANG, Chuying, Ningde, Fujian 352100 (CN)
(74) Representative: Kraus & Lederer PartGmbB
(86) International application number: PCT/CN2024/141567
(87) International publication number: WO 2025/161770

(57) **Abstract**

The present application relates to the field of photovoltaics. Provided are a solar cell module, a photovoltaic module, and an electric device. The solar cell module comprises a solar cell, a backsheet and a waterproof layer. The solar cell is electrically connected to busbars, each busbar having a lead-out end; the backsheet is located on a back face of the solar cell, and the backsheet is provided with a lead-out hole corresponding to the lead-out ends; and the waterproof layer is provided with a filling part and a connecting part which are connected to each other, wherein the filling part fills the inside of the lead-out hole and seals the lead-out hole, the lead-out ends pass through the filling part to protrude through the lead-out hole, and the connecting part circumferentially surrounds the filling part and is held between the solar cell and the backsheet. The present application can improve the waterproof capability at the lead-out hole, and can also improve the reliability of the waterproof layer.

## Description

### CROSS-REFERENCE TO RELATED APPLICATIONS

The present application claims priority to Chinese Patent Application No. 202420242014.3, filed with the China National Intellectual Property Administration on January 31, 2024 and entitled "SOLAR CELL MODULE, PHOTOVOLTAIC MODULE, AND ELECTRIC DEVICE", which is incorporated herein by reference in its entirety.

### TECHNICAL FIELD

The present application relates to the field of photovoltaics, and particularly relates to a solar cell module, a photovoltaic module, and an electric device.

### BACKGROUND

A backsheet of a solar cell module is provided with a lead hole for busbars to pass through. After passing through the lead hole, the busbars are connected into a junction box.

However, water vapor may easily enter in the solar cell module through the lead hole, and may cause water vapor erosion to the cell, thus compromising the output power of the solar cell module.

### SUMMARY

In view of the above problems, the present application provides a solar cell module, a photovoltaic module, and an electric device, which can solve the technical problem that water vapor erosion caused by a lead hole compromises the output power of the solar cell module.

In a first aspect, an embodiment of the present application provides a solar cell module, including a solar cell, a backsheet, and a waterproof layer.

The solar cell module includes the solar cell, the backsheet and the waterproof layer. The solar cell is electrically connected to busbars, and each busbar has a lead-out end; the backsheet is located on a back face of the solar cell, and the backsheet is provided with a lead hole corresponding to the lead-out ends; and the waterproof layer includes a filling part and a connecting part which are connected to each other. The filling part fills an interior of the lead hole and seals the lead hole, the lead-out ends extend out of the lead hole through the filling part, and the connecting part circumferentially surrounds the filling part, and is held between the solar cell and the backsheet.

In the technical solution of the embodiment of the present application, the waterproof layer is provided with the filling part and the connecting part which are connected to each other, the filling part fills the interior of the lead hole, and seals the lead hole, and the connecting part circumferentially surrounds the filling part, and is held between the solar cell and the backsheet. On one hand, the waterproof layer is disposed inside the solar cell module, the hole-plugging operation is completed in a hot pressing process. In addition, the connecting part circumferentially surrounds the filling part, and is stably held between the solar cell and the backsheet, which facilitates providing rigid confinement to the waterproof layer, making the connection among the waterproof layer, the backsheet, and the solar cell firmer, avoiding the failure risk of the waterproof layer, and further improving the water-oxygen stability of a device. On the other hand, the water vapor is discharged from the interior to exterior in the hot pressing process, so the inevitable residue of water vapor and the like in the solar cell module after encapsulation is favorably reduced, and the connection interface stability is improved.

In some embodiments, a water vapor transmission rate of the waterproof layer is less than 0.1 g/m²*d. By using the waterproof layer with the water vapor transmission rate less than 0.1 g/m²*d, the waterproof capability of the solar cell module at the lead hole can be effectively improved, and the compromise to the output power of the solar cell module can be further reduced.

In some embodiments, a water vapor transmission rate of the waterproof layer is 0.01 g/m²*d to 0.05 g/m²*d. By using the waterproof layer with the water vapor transmission rate within the above range, the waterproof capability of the solar cell module at the lead hole can be effectively improved, and the compromise to the output power of the solar cell module can be further reduced.

In some embodiments, a material of the waterproof layer is at least one of rubber, silica gel, a silica gel mixture, organic silicon rubber, or a rubber mixture. The above materials are easy to obtain, and have low water vapor transmission rate and good water resistance.

In some embodiments, a material of the waterproof layer is butyl rubber. The butyl rubber has excellent durability and good water resistance, and is favorable for continuously improving the waterproof capacity of the solar cell module at the lead hole, and the compromise to the output power of the solar cell module is further reduced.

In some embodiments, the waterproof layer is bonded between the solar cell and the backsheet. By using the bonding, the waterproof layer can be prevented from being displaced in a lamination process, the structural stability among the waterproof layer, the solar cell, and the backsheet is also favorably improved, and the water resistance is favorably improved.

In some embodiments, an area of the waterproof layer is smaller than an area of the backsheet. While improving the waterproof capability at the lead hole, the manufacturing cost is favorably reduced.

In some embodiments, a ratio of the area of the waterproof layer to the area of the backsheet is 1:20-1:100. While improving the waterproof capability at the lead hole, the manufacturing cost is favorably reduced.

In some embodiments, a junction box is disposed at a side of the backsheet facing away from the solar cell, the busbars are electrically connected to the junction box, and an orthographic projection of the waterproof layer on the backsheet is located in an orthographic projection of the junction box on the backsheet. While improving the waterproof capability at the lead hole, the manufacturing cost is reduced, and the aesthetics of the solar cell module is improved.

In some embodiments, the solar cell module further includes a backside encapsulant film located between the backsheet and the solar cell. The waterproof layer is located between the solar cell and the backside encapsulant film, and/or, the waterproof layer is located between the backsheet and the backside encapsulant film. The backside encapsulant film can achieve mechanical buffer protection on the solar cell, and provide supporting force among the waterproof layer, the backsheet and the solar cell.

In some embodiments, the solar cell is a perovskite solar cell.

In some embodiments, the solar cell module includes a transparent panel located on a front side of the solar cell. The transparent panel is favorable for further encapsulating the front side of the solar cell to inhibit or isolate water vapor immersion.

In some embodiments, the solar cell module further includes a sealing element, and the sealing element circumferentially surrounds the solar cell, and is bonded to the transparent panel and the backsheet respectively through lamination to form a sealed space for accommodating the solar cell. The solar cell module is effectively encapsulated to inhibit or isolate water vapor immersion.

In a second aspect, the present application provides a photovoltaic module. The photovoltaic module includes a plurality of electrically connected solar cell modules in the above embodiments.

In a third aspect, the present application provides an electric device. The electric device includes the solar cell module or the photovoltaic module provided in the above embodiments, and the solar cell module and the photovoltaic module are configured to provide electric energy for the electric device.

The above descriptions are merely an overview of the technical solutions of the present application. In order to understand the technical means of the present application more clearly, implementation may be performed according to content of the specification. Moreover, in order to make the above and other objectives, features, and advantages of the present application more comprehensible, specific implementations of the present application are particularly described below.

### BRIEF DESCRIPTION OF THE DRAWINGS

Various other advantages and benefits will become apparent to those of ordinary skill in the art upon reading the following detailed description of the exemplary implementations. The accompanying drawings are merely used for illustrating the exemplary implementations, and are not intended to constitute a limitation on the present application. In addition, in all the accompanying drawings, same parts are indicated by the same reference numerals. In the accompanying drawings,
FIG. 1 is a schematic structural diagram of a solar cell module provided in an embodiment of the present application;
FIG. 2 is a schematic structural diagram of a solar cell module provided in an embodiment of the present application;
FIG. 3 is a schematic assembly diagram of a waterproof layer and a backsheet provided in an embodiment of the present application; and
FIG. 4 is a schematic structural diagram of a solar cell module provided in an embodiment of the present application.

In the figures,
1000 denotes a solar cell module;
11 denotes a solar cell; 14 denotes a backside encapsulant film; 15 denotes a waterproof layer; 16 denotes a backsheet; 17 denotes a busbar; 18 denotes a junction box; 19 denotes a sealing element;
151 denotes a filling part; 153 denotes a connecting part; 161 denotes a lead hole; 171 denotes a lead-out end;
111 denotes a transparent conductive glass substrate; 112 denotes a hole transport layer; 113 denotes a perovskite light-absorbing layer; 114 denotes an electron transport layer; 115 denotes a metal fluoride layer; and 116 denotes an electrode layer.

### DETAILED DESCRIPTION

The embodiments of the technical solutions of the present application need to be described in detail below with reference to the accompanying drawings. The following embodiments are only used to illustrate the technical solutions of the present application more explicitly, and are thus only interpreted as examples, rather than used to limit the protection scope of the present application.

Unless otherwise defined, all technical and scientific terms used herein have the same meaning as commonly understood by those skilled in the technical field to which the present application relates. The terminology used herein is for the purpose of describing particular embodiments only and is not intended to limit the present application. The terms "including" and "having" and any variations thereof in the description and claims of the present application and the foregoing description of the accompanying drawings are intended to cover non-exclusive inclusions.

In the descriptions of the embodiments of the present application, the technical terms "first", "second", etc. are intended only to distinguish different objects, and should not be understood as indicating or implying relative importance or implying the quantity, specific order, or primary and secondary relationship of indicated technical features. In the descriptions of the embodiments of the present application, "a plurality of" means two or more, unless otherwise expressly and specifically defined.

"Embodiment" mentioned herein means that particular features, structures, or features described with reference to the embodiment may be included in at least one embodiment of the present application. The term appearing at different positions of the specification may not refer to the same embodiment or an independent or alternative embodiment that is mutually exclusive with another embodiment. A person skilled in the art explicitly or implicitly understands that the embodiments described herein may be combined with other embodiments.

In the descriptions of embodiments of the present invention, the term "and/or" used herein merely refers to an association relationship describing associated objects, meaning that there may be three relationships, for example, A and/or B, which may mean: there are three cases of A alone, A and B together, and B alone. In addition, the character "/" used herein generally indicates that the former and later associated objects have an "or" relationship.

In the descriptions of the embodiments of the present application, the term "a plurality of" refers to two or more (including two), and similarly, "a plurality of groups" refers to two or more groups (including two groups); and "a plurality of pieces" refers to two or more pieces (including two pieces).

In the descriptions of the embodiments of the present application, the orientations or positional relationships indicated by the technical terms such as "center", "longitudinal", "transverse", "length", "width", "thickness", "upper", "lower", "front", "rear", "left", "right", "vertical", "horizontal", "top", "bottom", "interior", "exterior", "clockwise", "counterclockwise", "axial", "radial", and "circumferential" are based on the orientations or positional relationships shown in the accompanying drawings, and are only for the convenience of describing the present application and simplifying the descriptions, rather than indicating or implying that the involved device or element should have a specific orientation or should be configured or operated in the specific orientation, and therefore cannot be understood as limitations on the embodiments of the present application.

In the descriptions of the embodiments of the present application, unless otherwise explicitly specified and defined, the technical terms "mounted", "connected", "connect", "fixed", and the like should be understood in a broad sense. For example, a connection may refer to a fixed connection, a detachable connection, or an integral connection; a mechanical connection or an electrical connection; a direct connection, an indirect connection via an intermediate medium, internal communication between two elements, or an interaction between two elements. For those of ordinary skill in the art, the specific meaning of the above terms in the embodiments of the present application may be understood according to specific circumstances.

Solar cells are green energy cells. At present, from the development of market situations, the application of the solar cells becomes wider. The solar cells are not only applied to photovoltaic modules such as a power station, but also gradually applied to electric devices such as an electric automobile. With continuous expansion of the application fields of the solar cells, market demands of the solar cells are also expanding.

After being immersed in water vapor, a solar cell is easily damaged by corrosion, it causes a loss of a cell function, and also causes great attenuation of the module performance. Therefore, encapsulation to prevent water vapor immersion is especially important for the solar cell module. A lead hole for busbars to pass through is formed in a backsheet of an existing solar cell module, the busbars are connected into a junction box after passing through the lead hole. However, water vapor may easily enter the solar cell module through the lead hole, and may cause water vapor erosion to the solar cell, thus compromising the output power of the solar cell module.

In order to solve the above problems, generally, after the solar cell, the backsheet, and the like are assembled and hot-pressed and encapsulated (also referred to as laminated), a sealing adhesive layer for sealing the lead hole is formed through curing after adhesive filling into the lead hole from the exterior of the backsheet. However, the above operation has the following defects: 1. The filled adhesive may only fill the lead hole; 2. The adhesive filling is from the exterior to the interior, pores may be formed in a connection interface of the sealing adhesive layer and the hole wall of the lead hole since air may be discharged not timely, affecting the connection interface stability, or the water vapor may not be thoroughly discharged and remains in the sealing process; and 3. The sealing adhesive layer is combined with the hole wall of the lead hole only through adhesive force, so the sealing adhesive layer is easy to be released or displaced under external stress, affecting the sealing effect, and resulting in poor endurance.

Therefore, in order to solve the above problems, the present application provides a solar cell module, including a solar cell, a backsheet, and a waterproof layer.

The solar cell is electrically connected to busbars, and each busbar has a lead-out end; the backsheet is located on a back face of the solar cell, and the backsheet is provided with a lead hole corresponding to the lead-out ends; and the waterproof layer includes a filling part and a connecting part which are connected to each other. The filling part fills an interior of the lead hole and seals the lead hole, the lead-out ends extend out of the lead hole through the filling part, and the connecting part circumferentially surrounds the filling part, and is held between the solar cell and the backsheet.

In the present application, by using the waterproof layer is provided with the filling part and the connecting part which are connected to each other, the filling part fills the interior of the lead hole, and seals the lead hole, and the connecting part circumferentially surrounds the filling part, and is held between the solar cell and the backsheet. On one hand, the waterproof layer is disposed inside the solar cell module, the hole-plugging operation is completed in a hot pressing process. In addition, the connecting part circumferentially surrounds the filling part, and is stably held between the solar cell and the backsheet, which facilitates providing rigid confinement to the waterproof layer, making the connection among the waterproof layer, the backsheet, and the solar cell firmer, avoiding the failure risk of the waterproof layer, and further improving the water-oxygen stability of a device. On the other hand, the water vapor is discharged from the interior to exterior in the hot pressing process, so the inevitable residue of water vapor and the like in the solar cell module after encapsulation is favorably reduced, and the connection interface stability is improved.

The technical solution of the present application will be exemplarily described with reference to embodiments below.

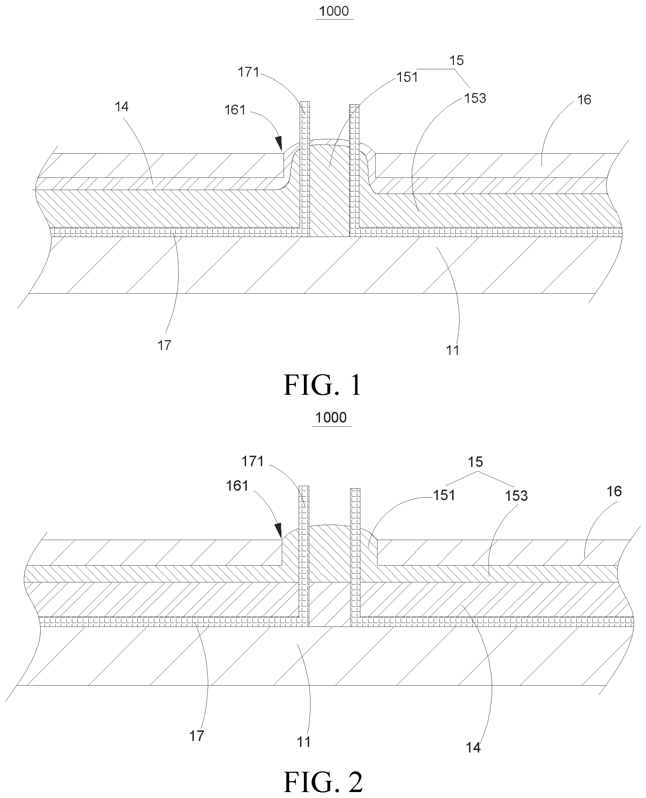

Referring to FIG. 1 and FIG. 2, according to some embodiments of the present application, the solar cell module 1000 includes a solar cell 11, a backsheet 16, and a waterproof layer 15.

The solar cell 11 is electrically connected to busbars 17, and each busbar 17 has a lead-out end 171. The backsheet 16 is located on a back face of the solar cell 11, and the backsheet 16 is provided with a lead hole 161 corresponding to the lead-out ends 171. The waterproof layer 15 includes a filling part 151 and a connecting part 153 which are connected to each other. The filling part 151 fills an interior of the lead hole 161 and seals the lead hole 161, the lead-out ends 171 extend out of the lead hole 161 through the filling part 151, and the connecting part 153 circumferentially surrounds the filling part 151, and is held between the solar cell 11 and the backsheet 16.

The solar cell 11 may be, but is not limited to, a single crystalline silicon solar cell, a polycrystalline silicon solar cell, or a perovskite solar cell. It may be understood that the solar cell 11 has a front side and a back face which are opposite to each other. The front side is a face of the solar cell 11 facing the sunlight when the solar cell module 1000 operates normally, and the back face is a face of the solar cell 11 facing away from the sunlight when the solar cell module 1000 operates normally.

The busbars 17 may be made of a conductive metal, and include, but is not limited to, copper strips, aluminum strips, etc. The busbars 17 include a positive electrode busbar and a negative electrode busbar, the positive electrode busbar is electrically connected to a positive electrode of the solar cell 11, and the negative electrode busbar is electrically connected to a negative electrode of the solar cell 11, so as to realize the outward electric energy output.

The backsheet 16 refers to a plate facing away from sunlight during normal operation of the solar cell module 1000. The backsheet 16 is located on the back face of the solar cell 11, so as to encapsulate the back face of the solar cell 11 and avoid the water vapor immersion. The backsheet 16 includes but is not limited to a glass plate, a metal composite plate, a composite polymer plate with a metal film layer, or a composite polymer plate with an inorganic non-metallic film layer. In this case, each of the above backsheets 16 has the excellent water vapor blocking capability. Exemplarily, the backsheet is a transparent glass plate.

The lead hole 161 on the backsheet 16 is configured to provide a channel for the busbars 17 to extend out of the solar cell module 1000. That the lead-out ends 171 extend out of the lead hole 161 through the filling part 151 refers to that the filling part 151 is provided with an encapsulation surface facing away from the solar cell 11, and the lead-out ends 171 pass through the filling part 151 and extend out of the encapsulation surface of the filling part 151.

The waterproof layer 15 is a member having a specific water resistance capability.

It may be understood that the filling part 151 and the connecting part 153 are integrally formed, the filling part 151 fills the interior of the lead hole 161 and seals the lead hole 161, and the connecting part 153 circumferentially surrounds the filling part 151 and is held between the solar cell 11 and the backsheet 16. Therefore, in a practical preparation process, the waterproof layer 15 is located between the solar cell 11 and the backsheet 16, an orthographic projection of the lead hole 161 in the lamination direction of the solar cell 11 and the backsheet 16 is located in the waterproof layer 15. In this way, in the hot pressing process, a part of waterproof layer 15 may fill the interior of the lead hole 161 under the effect of hot pressure and seals the lead hole 161 to form the filling part 151. The rest waterproof layer 15 is stably held between the solar cell 11 and the backsheet 16. Compared with a method of sealing by adhesive injection after lamination, this method has the following advantages: 1. With the waterproof layer being held between the solar cell 11 and the backsheet 16 by using the connecting part 153, the stability of the waterproof layer 15 is effectively improved, an interface separation is effectively avoided, the water resistance is improved, and the busbars 17 are effectively fixed. 2. Even if the water vapor enters the solar cell module 1000 through the lead hole 161, since the filling part 151 and the connecting part 153 are integrally formed, a path for the water vapor to enter the solar cell module 1000 is effectively lengthened, and the water resistance property is improved. 3. Air, water, and the like are discharged from the interior to the exterior under the hot pressing, so the inevitable residue of water vapor, and the like in the solar cell module after encapsulation is favorably reduced.

It may be understood that, that the connecting part 153 is held between the solar cell 11 and the backsheet 16 refers to that the connecting part 153 may be directly in contact with the solar cell 11 and the backsheet 16, or another layer structure may be added. Exemplarily, as shown in FIG. 1 and FIG. 2, in addition to the connecting part 153, a backside encapsulant film 14 is also held between the solar cell 11 and the backsheet 16. The solar cell 11, the connecting part 153, the back side encapsulant film 14, and the backsheet 16 are arranged in a laminated manner.

Based on the above, according to the solar cell module 1000 provided by the present application, by using an arrangement manner that the waterproof layer 15 is provided with the filling part 151 and the connecting part 153 which are connected to each other, the filling part 151 fills the interior of the lead hole 161, and seals the lead hole 161, and the connecting part 153 circumferentially surrounds the filling part 151, and is held between the solar cell 11 and the backsheet 16. On one hand, the waterproof layer 15 is disposed inside the solar cell module 1000, the hole-plugging operation is completed in a hot pressing process. In addition, the connecting part 153 circumferentially surrounds the filling part 151, and is stably held between the solar cell 11 and the backsheet 16, which facilitates providing rigid confinement to the waterproof layer 15, making the connection among the waterproof layer 15, the backsheet 16, and the solar cell 11 firmer, avoiding the failure risk of the waterproof layer 15, and further improving the water-oxygen stability of a device. On the other hand, the water vapor is discharged from the interior to exterior in the hot pressing process, so the inevitable residue of water vapor, and the like in the solar cell module 1000 after encapsulation is favorably reduced, and the connection interface stability is improved.

That is, through the introduction and the disposing position of the waterproof layer 15 in the solar cell module 1000 provided by the present application, the waterproof capability at the lead hole 161 is improved, the reliability of the waterproof layer 15 may be improved, and the compromise to the output power of the solar cell module 1000 is reduced.

Optionally, the filling part 151 and the connecting part 153 are integrally formed.

It may be understood that an insulation layer (not shown) is disposed to prevent a short circuit in a region in which the busbars 17 may be in contact with the solar cell 11 to cause the short circuit.

The quantity of the lead hole 161 may be one or two.

When the quantity of the lead hole 161 is one, the positive electrode busbar and the negative electrode busbar are led out from the same lead hole 161.

When the quantity of the lead holes 161 is two, the two lead holes 161 are respectively disposed correspondingly to the positive electrode busbar and the negative electrode busbar, and the positive electrode busbar and the negative electrode busbar are respectively led out from the two respective lead holes 161.

In addition to the above structure improvement, a related material having excellent water resistance performance may also be selected to further improve the waterproof capability at the lead hole 161.

According to some embodiments of the present application, a water vapor transmission rate of the waterproof layer 15 is less than 0.1 g/m²*d.

The water vapor transmission rate is a physical quantity representing a water vapor blocking effect of the waterproof layer 15. The film may be tested according to Standard GB/T 21529-2008 by using a water vapor transmission rate tester.

By using the waterproof layer 15 with the water vapor transmission rate less than 0.1 g/m²*d, the waterproof capability of the solar cell module 1000 at the lead hole 161 can be effectively improved, and the compromise to the output power of the solar cell module 1000 can be further reduced.

According to some embodiments of the present application, a water vapor transmission rate of the waterproof layer 15 is 0.01 g/m²*d to 0.05 g/m²*d.

By using the waterproof layer 15 with the water vapor transmission rate within the above range, the waterproof capability of the solar cell module 1000 at the lead hole can be effectively improved, and the compromise to the output power of the solar cell module 1000 can be further reduced.

Exemplarily, the water vapor transmission rate of the waterproof layer 15 is any one value or a value between any two values of 0.01 g/m²*d, 0.02 g/m²*d, 0.03 g/m²*d, 0.04 g/m²*d or 0.05 g/m²*d.

According to some embodiments of the present application, a material of the waterproof layer 15 is at least one of rubber, silica gel, a silica gel mixture, organic silicon rubber, or a rubber mixture.

The rubber includes, but is not limited to, polyisobutene or butyl rubber, etc., and it may be selected by those skilled in the art according to an actual requirement.

The rubber mixture refers to a mixture in which rubber is used as a main material but is mixed with various additives, fillers, etc.

The silica gel mixture refers to a mixture in which silica gel is used as a main material but is mixed with various additives, fillers, etc.

The above materials are easy to obtain, and have low water vapor transmission rate and good water resistance.

In addition to the materials shown above, the waterproof layer 15 may also be made of a hybrid material as long as a required waterproof level can be achieved, and this is not specifically limited.

It may be understood that the above materials are all existing materials, and the embodiments of the present application do not seek to protect the composition of the waterproof layer 15, and the above structure achieves a waterproof effect by only using characteristics of the existing materials. Those skilled in the art may flexibly select different materials according to different use requirements to achieve corresponding waterproof requirements.

According to some embodiments of the present invention, a material of the waterproof layer 15 is butyl rubber.

The butyl rubber has excellent durability and good water resistance, and is favorable for continuously improving the waterproof capacity of the solar cell module 1000 at the lead hole 161, and the compromise to the output power of the solar cell module 1000 is further reduced.

It should be noted that the waterproof layer 15 may be directly held between the solar cell 11 and the backsheet 16.

According to some embodiments of the present application, the waterproof layer 15 is bonded between the solar cell 11 and the backsheet 16. By using the bonding, on one hand, the waterproof layer 15 can be conveniently located and prevented from being displaced in a lamination process, and on the other hand, the structural stability among the waterproof layer 15, the solar cell 11, and the backsheet 16 is also favorably improved, and the water resistance is favorably improved.

It may be understood that, that the waterproof layer 15 is bonded between the solar cell 11 and the backsheet 16 refers to that the waterproof layer 15 has adhesive force. That is, that the waterproof layer 15 is bonded between the solar cell 11 and the backsheet 16 refers to that the filling part 151 is bonded to the hole wall of the lead hole 161, and the connecting part 153 is bonded to the solar cell 11 and the backsheet 16 respectively.

The waterproof layer 15 with the adhesive force may exist in a form of an adhesive strip, an adhesive tape, or an adhesive film formed by curing a liquid adhesive, and this is not specifically limited.

Exemplarily, the material of the waterproof layer 15 is a butyl adhesive strip, a butyl adhesive tape, or a butyl adhesive film formed by curing a liquid butyl adhesive.

The waterproof layer 15 is disposed on the back face of the solar cell 11, so the disposition of the waterproof layer 15 does not influence sunlight absorption of the solar cell 11. Therefore, the waterproof layer 15 may be laid on the entire back face of the solar cell 11, or may be only disposed in a local region corresponding to the lead hole 161 as long as after lamination, the waterproof layer 15 has a filling part 151 capable of filling the interior of the lead hole 161 and sealing the lead hole 161, and a connecting part 153 circumferentially surrounding the filling part 151 and held between the solar cell 11 and the backsheet 16.

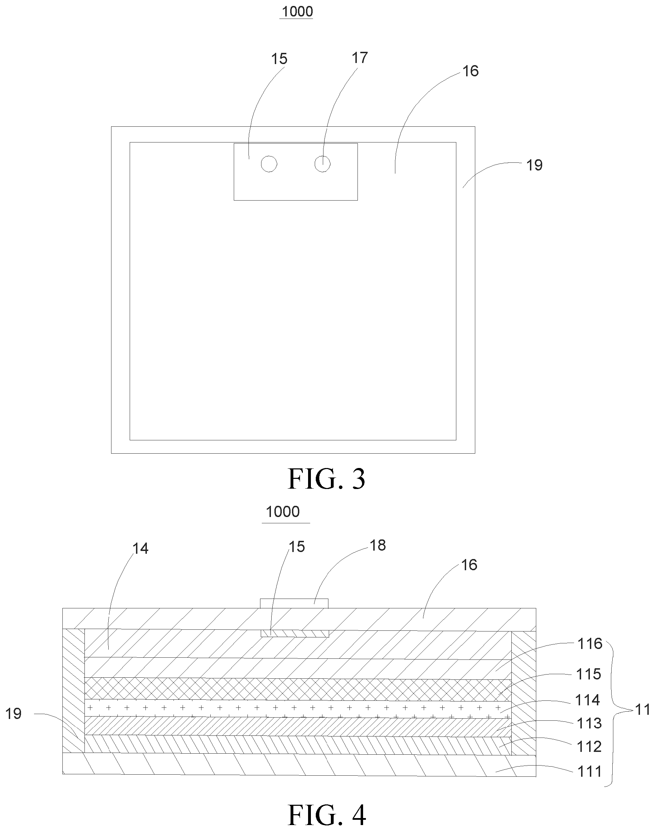

As shown in FIG. 3, according to some embodiments of the present application, an area of the waterproof layer 15 is smaller than an area of the backsheet 16.

That is, the waterproof layer 15 is disposed in a local region corresponding to the lead hole 161 rather than covering the entire back face of the solar cell 11.

Through the above arrangement, while improving the waterproof capability at the lead hole 161 of the solar cell module 1000, the manufacturing cost is favorably reduced.

According to some embodiments of the present application, a ratio of the area of the waterproof layer 15 to the area of the backsheet 16 is 1:20 to 1:100.

Within the above range, while improving the waterproof capability at the lead hole 161 of the solar cell module 1000, the manufacturing cost is reduced.

Exemplarily, the ratio of the area of the waterproof layer 15 to the area of the backsheet 16 is any one value or a value between any two values of 1:20, 1:30, 1:40, 1:50, 1:60, 1:70, 1:80, 1:90, or 1:100.

As shown in FIG. 4, according to some embodiments of the present application, a junction box 18 is disposed at a side of the backsheet 16 facing away from the solar cell 11, the busbars 17 are electrically connected to the junction box 18, and an orthographic projection of the waterproof layer 15 on the backsheet 16 is located in an orthographic projection of the junction box 18 on the backsheet 16. The junction box 18 is configured to realize external connection of the solar cell module 1000 to an electric device. The junction box 18 has a positive terminal and a negative terminal. The positive terminal is configured to be electrically connected to the positive electrode busbar. The negative terminal is electrically connected to the negative electrode busbar. An electrical connection manner is, for example, soldering. The junction box 18 may be connected to the backsheet 16 in a bonding manner. During actual use, the junction box 18 may be filled with a liquid adhesive such as organic silicone gel. After the liquid adhesive is completely cured, a waterproof filling layer is formed.

It may be understood that, that the position of the junction box 18 corresponds to the lead hole 161, and the orthographic projection of the waterproof layer 15 on the backsheet 16 is located in the orthographic projection of the junction box 18 on the backsheet 16 refers to that the area of the orthographic projection of the junction box 18 on the backsheet 16 is greater than or equal to the area of the orthographic projection of waterproof layer 15 on the backsheet 16.

Through enabling the orthographic projection of the waterproof layer 15 on the backsheet 16 to be located in the orthographic projection of the junction box 18 on the backsheet 16. On one hand, while improving the waterproof capability at the lead hole 161 of the solar cell module 1000, the manufacturing cost is reduced. On the other hand, the waterproof layer 15 may be shielded by the junction box 18, so the aesthetics of the solar cell module 1000 can be improved.

It should be noted that the backsheet 16 and the solar cell 11 may be provided with only the waterproof layer 15. In this case, in order to fill the filling part 151 to the interior of the lead hole 161 and seal the lead hole 161 after the lamination, the thickness of the filling part 151 before lamination may be properly increased.

In addition to the above arrangement, referring to FIG. 1, FIG. 2, and FIG. 4, according to some embodiments of the present application, the solar cell module 1000 further includes a backside encapsulant film 14 located between the backsheet 16 and the solar cell 11. As shown in FIG. 1, the waterproof layer 15 is located between the solar cell 11 and the backside encapsulant film 14, and/or, as shown in FIG. 2, the waterproof layer 15 is located between the backsheet 16 and the backside encapsulant film 14.

The backside encapsulant film 14 can achieve mechanical buffer protection on the solar cell 11, and provide supporting force among the waterproof layer 15, the backsheet 16 and the solar cell 11. In addition, the backside encapsulant film 14 has adhesive force, and may also improve the connection stability to the waterproof layer 15, the solar cell, and the backsheet 16.

The backside encapsulant film 14 may be an ethylene-vinyl acetate copolymer film (EVA film), a polyvinyl butyral film (PVB film), a thermoplastic polyurethane film (TPU film), a polydimethylsiloxane film (PDMS film), a polyolefin elastomer film (POE film), an ionomer ethylene copolymer film, etc.

Optionally, as shown in FIG. 2, the waterproof layer 15 is located between the backsheet 16 and the backside encapsulant film 14.

Through the above arrangement, the waterproof layer 15 is favorably to directly fill the interior of the lead hole 161 and seal the lead hole 161 after the lamination, so as to effectively block the water vapor in time, and the water blocking effect is better.

According to some embodiments of the present application, the solar cell 11 is a perovskite solar cell.

In the perovskite solar cell, a light-absorbing layer mainly consists of a perovskite material. When receiving sunlight, the perovskite layer absorbs photons first to generate electron-hole pairs (excitons). Under the action of the p-n junction electric field, the excitons are first separated into electrons and holes, which are then respectively transported to a cathode and an anode. Photo-generated holes flow to the p region. Photo-generated electrons flow to the n region. An electric current is formed when a circuit is connected.

The perovskite solar cell generally includes functional layers such as a transparent substrate layer, a first carrier transport layer, a perovskite light-absorbing layer 113, a second carrier transport layer, and an electrode layer 116. Either one of the first carrier transport layer and the second carrier transport layer is a hole transport layer 112, and the other is an electron transport layer 114. In the perovskite solar cell, a corresponding modification layer may be inserted between the layers.

The transparent conductive substrate includes, but is not limited to, the following materials: FTO, ITO, AZO, BZO, IZO, etc.

The chemical formula of the perovskite light-absorbing layer 113 satisfies ABX₃ or A₂CDX₆, where A is an inorganic or organic or organic-inorganic mixed cation, including but not limited to at least one of the following materials: methylammonium ion (CH3NH³⁺), formamidinium ion (HC(NH2)²⁺), cesium ion (Cs⁺), and rubidium ion (Rb⁺), and the like, B is an inorganic or organic or organic-inorganic mixed cation, including but not limited to at least one of the following materials: divalent metal ions Pb²⁺ and tin Sn2⁺, and the like, C is an inorganic or organic or organic-inorganic mixed cation, including but not limited to the following materials: monovalent metal ions Ag⁺, and the like, D is an inorganic or organic or organic-inorganic mixed cation, including but not limited to the following materials: trivalent metal ions Bi³⁺, etc., and X is an inorganic or organic or organic-inorganic mixed anion, including but not limited to at least one of the following materials: chloride ion (Cl⁻), bromide ion (Br⁻), iodide ion (I⁻), and the like.

Exemplarily, the band gap of the perovskite layer is 1.20 eV to 2.30 eV, and the thickness thereof is 200 nm to 1000 nm.

The electron transport layer 114 is at least one of the following materials, a derivative thereof, and a material obtained by doping or passivation: [6,6]-phenyl C₆₁ methyl butyrate (PC₆₁BM), [6,6]-phenyl C₇₁ methyl butyrate (PC₇₁BM), fullerene C60 (C60), fullerene C70 (C70), and tin dioxide (SnO₂), zinc oxide (ZnO), etc.

The hole transport layer 112 is at least one of the following materials, derivatives thereof, and materials obtained by means of doping or passivation: poly[bis(4-phenyl)(2,4,6-trimethylphenyl)amine] (PTAA), 2,2',7,7'-tetrakis[N,N-di(4-methoxyphenyl)amino]-9,9'-spirobifluorene (Spiro-OMeTAD), poly(3-hexylthiophene) (P3HT), triptycene-cored triphenylamine (H101), 3,4-ethylenedioxythiophene-methoxytriphenylamine (EDOT-OMeTPA), N-(4-aniline)carbazole-spirobifluorene (CzPAF-SBF), poly(3,4-ethylenedioxythiophene):poly(styrenesulfonate) (PEDOT:PSS), polythiophene, nickel oxide (NiOx), molybdenum oxide (MoO₃), cuprous iodide (CuI), cuprous oxide (CuO), etc.

A material of the electrode layer 116 is an organic or organic or hybrid organic and non-organic conductive material, and includes, but is not limited to, at least one of the following materials: Ag, Cu, C, Au, AI, ITO, AZO, BZO, IZO, etc.

For example, as shown in FIG. 4, when the solar cell 11 is a perovskite solar cell, the structure of the perovskite solar cell is as follows: a transparent conductive glass substrate 111, a metal fluoride layer 115, an electron transport layer 114, a perovskite light-absorbing layer 113, a hole transport layer 112, and an electrode layer 116 in sequential lamination. Alternatively, the structure of the perovskite solar cell is as follows: a transparent conductive glass substrate 111, a hole transport layer 112, a perovskite light-absorbing layer 113, an electron transport layer 114, a metal fluoride layer 115, and an electrode layer 116 in sequential lamination. The electrode layer 116 is a metal electrode or a transparent conductive electrode. A corresponding modification layer may be inserted between the layers.

A material of the metal fluoride layer 115 includes, but is not limited to, lithium fluoride. It may be selected by those skilled in the art according to an actual requirement.

According to some embodiments of the present application, the solar cell module 1000 includes a transparent panel located on a front side of the solar cell 11.

The transparent panel is favorable for further encapsulating the front side of the solar cell 11 to inhibit or isolate water vapor immersion.

It should be noted that when the solar cell 11 is a perovskite solar cell, the transparent panel may be, as shown in FIG. 4, a transparent substrate layer inherent to the perovskite solar cell, or may be an additionally disposed transparent panel.

It may be understood that when the transparent panel is not a transparent substrate layer inherent to the perovskite solar cell but an additionally disposed transparent panel, a frontside encapsulant film (not shown) of the solar cell module 1000 may be disposed between the transparent panel and the solar cell 11, and the frontside encapsulant film is bonded between the transparent panel and the solar cell 11. In this case, the frontside encapsulant film may be used to perform mechanical buffer protection on the solar cell 11, and to improve the stability between the frontside encapsulant film and the solar cell as well as the transparent panel.

The frontside encapsulant film may be an ethylene-vinyl acetate copolymer film (EVA film), a polyvinyl butyral film (PVB film), a thermoplastic polyurethane film (TPU film), a polydimethylsiloxane film (PDMS film), a polyolefin elastomer film (POE film), an ionomer ethylene copolymer film, etc.

Referring to FIG. 4, according to some embodiments of the present application, the solar cell module 1000 further includes a sealing element 19. The sealing element 19 circumferentially surrounds the solar cell 11. The sealing element 19 is bonded to the transparent panel and the backsheet 16 respectively through lamination to form a sealed space for accommodating the solar cell 11.

Through the above arrangement, the solar cell module is effectively encapsulated to inhibit or isolate water vapor immersion.

The sealing element 19 is bonded to the periphery of the solar cell 11. Through the bonding, the connection stability between the sealing element 19 and another component may be improved, and the displacement during lamination is favorably avoided.

The water vapor transmission rate of the sealing element 19 may be referred to that of the waterproof layer 15. A material of the sealing element 19 is rubber, silica gel, or organic silicon rubber.

Exemplarily, the sealing element 19 is a butyl rubber type adhesive strip or adhesive tape.

It should be noted that the solar cell module 1000 in the embodiments of the present application may further include components such as a frame, and related arrangement may be performed according to a specific use condition. Details are not excessively described herein.

Exemplarily, referring to FIG. 2, FIG. 3, and FIG. 4, the waterproof layer 15 is located between the backsheet 16 and the backside encapsulant film 14. A method for preparing the solar cell module 1000 includes:

The solar cell 11 grows or is put on the transparent panel. An insulation layer (not shown) is disposed in a region in which the solar cell 11 may be in contact with the busbars 17 to cause a short circuit. Then, the busbars 17 are soldered to the solar cell 11 to realize electrical connection. Next, the sealing element 19 is bonded around the solar cell 11, with an overflow adhesive space reserved. Next, the backside encapsulant film 14 is laid on the front side of the solar cell 11. A through hole for the busbars 17 to extend out is formed in the backside encapsulant film 14. Then, the waterproof layer 15 is bonded to the surface of the backside encapsulant film 14, the lead-out ends 171 of the busbars 17 extend out of the waterproof layer 15. Then, the backsheet 16 with the lead hole 161 is disposed on the side of the waterproof layer 15 facing away from the backside encapsulant film 14, allowing the lead-out ends 171 to extend out of the backsheet 16 through the lead hole 161. The assembled structure is then put into a lamination machine to undergo a hot pressing operation, so that the waterproof layer 15 is pressed by the solar cell 11 and the backsheet 16. A part of the waterproof layer 15 fills the interior of the lead hole 161 and seals the lead hole 161 to form the filling part 151. The lead-out ends 171 pass out of the lead hole 161 through the filling part 151. The rest waterproof layer 15 is used as the connecting part 153 to circumferentially surround the filling part 151 and be held between the solar cell 11 and the backsheet 16.

After the lamination is completed, the junction box 18 may be bonded to the backsheet 16, and the busbars 17 are electrically connected to a connection terminal of the junction box 18 through soldering. Finally, a 1: 1 mixed organic silicone gel is injected into the junction box 18 by using an adhesive gun, and the gel is allowed to fully cure.

According to some embodiments of the present application, the present application further provides a photovoltaic module. The photovoltaic module includes a plurality of electrically connected solar cell modules mentioned above.

A plurality of refers to the integer quantity of two or more.

A photovoltaic module refers to a power generation system which uses a photo-generated voltaic effect to directly convert solar radiation energy into electric energy, and includes an independent photovoltaic module (Stand-alone PV System) and a grid-connected photovoltaic module (Grid-connected PV System). The independent photovoltaic module consists of a solar photovoltaic array consisting of the solar cell module, a storage battery, a charging controller, a power electronic converter (inverter), a load, and the like. The grid-connected photovoltaic module consists of a photovoltaic array, a high-frequency DC/DC boosting circuit, a power electronic converter (inverter), and a system monitoring part.

According to some embodiments of the present application, the present application further provides an electric device. The electric device includes the solar cell module or the photovoltaic module provided in the above solutions. The solar cell module and the photovoltaic module are configured to provide electric energy for the electric device.

The electric device may take various forms, such as an electric automobile, a ship, a spacecraft, a solar water heater, or a solar device. A power supply manner of the electric device may be single power supply by the solar cell module, and may also be cooperation power supply by the solar cell module and an energy storage battery. That is, the electric device is provided with the solar cell module and the energy storage battery at the same time. The energy storage battery is not limited to a primary battery and a secondary battery, for example, but is not limited to a lithium-ion secondary battery, a sodium-ion secondary battery, etc.

Some specific embodiments are listed below to better explain the present application.

In the following embodiments and comparative examples, the perovskite solar cell was obtained in the following manners:
1) FTO conductive glass with a specification of 30*30 cm was selected, etched ITO conductive glass was sequentially ultrasonically cleaned with water, acetone, and isopropanol several times, the solvent was blown dry under a nitrogen gun, and the ITO conductive glass was put into an ultraviolet ozone machine for further cleaning, and was used as a transparent conductive glass substrate.
2) After the spin coating of 2 mg/mL PTAA slurry at a rate of 5000 rpms/s on the ITO conductive glass after ultraviolet ozone processing, annealing processing was performed on a 100°C heating stage for 10 min to obtain a hole transport layer.
3) Perovskite precursor liquid was coated into the prepared hole transport layer through spin coating at 1000 to 5000 rpm/s, annealing was performed at 100°C for 30 min, and cooling was performed to reach room temperature to obtain a perovskite light-absorbing layer, and an active material of the perovskite light-absorbing layer was FA_{0.83}Cs_{0.17}PbI₃.
4) A slice obtained in step 3) was put into a thermal evaporator, when the vacuum degree for evaporation was lowered to a value below 5*10⁻⁴ Pa, 1 nm of metal fluoride of lithium fluoride was evaporated onto the perovskite light-absorbing layer at a rate of 0.02 A/s, then, 30 nm of an electron transport layer was evaporated at a rate of 0.05 A/s, and finally, 80 nm of a back electrode layer was evaporated at a rate of 0.1 A/s. The perovskite solar cell was obtained.

### Embodiment 1

Referring to FIG. 4, a solar cell module 1000 includes a solar cell 11, a backside encapsulant film 14, a waterproof layer 15, and a backsheet 16 sequentially in laminated arrangement, and includes a sealing element 19 surrounding the periphery of the solar cell 11.

The solar cell 11 is a perovskite solar cell, and includes a transparent conductive glass substrate 111, a hole transport layer 112, a perovskite light-absorbing layer 113, an electron transport layer 114, a metal fluoride layer 115, and an electrode layer 116 in sequential lamination. The transparent conductive glass substrate 111 of the perovskite solar cell is used as a transparent panel of the solar cell module 1000.

The sealing element 19 is bonded to the transparent panel and the backsheet 16 respectively through lamination to form a sealed space for accommodating the solar cell 11, the backside encapsulant film 14, and the waterproof layer 15.

Referring to FIG. 2, FIG. 3, and FIG. 4, the solar cell 11 is electrically connected to busbars 17. Each busbar 17 has a lead-out end 171, and an insulation adhesive (not shown) is disposed to prevent a short circuit in a region in which the busbars 17 may be in contact with the solar cell 11 to cause the short circuit. The backsheet 16 is provided with a lead hole 161 corresponding to the lead-out end 171.

The waterproof layer 15 includes a filling part 151 and a connecting part 153 connected to each other. The filling part 151 fills the interior of the lead hole 161 and seals the lead hole 161. The connecting part 153 circumferentially surrounds the filling part 151, and is held between the solar cell 11 and the backsheet 16. The lead-out ends 171 extend out of the lead hole 161 through the filling part 151.

In this embodiment, the area of the waterproof layer 15 is smaller than the area of the backsheet 16.

The waterproof layer 15 and the sealing element 19 are both butyl adhesive tapes.

### Comparative example 1

The difference from Embodiment 1 is only in that: no waterproof layer is provided; instead, after the lamination, a liquid butyl adhesive is injected into the lead hole from a side of the backsheet facing away from the solar cell, and the liquid butyl adhesive is cured to seal the lead hole.

### Test example

Before an aging test on the solar cell module prepared in Embodiment 1 and Comparative Example 1, a device performance test was performed under a 100 mW/cm² light source by using Keithley2400SMU, AM 1.5 G solar irradiation. The performance of the solar cell module provided in Comparative example 1 was not obviously different from that of the solar cell module provided in Embodiment 1.

The solar cell modules prepared in Embodiment 1 and Comparative example 1 were separately put in an 85°C/85% RH test box for an aging test, and the photoelectric conversion efficiency of the solar cell modules was determined.

A test manner of the photoelectric conversion efficiency was as follows: under a 100 mW/cm² light source, the performance of the cell was tested, and the photoelectric conversion efficiency was calculated as follows:

$\begin{matrix}PCE = Pout / Popt \\ = Voc \times Jsc \times \left(Vmpp\times Jmpp\right) / \left(Voc\times Jsc\right) \\ = Voc \times Jsc \times FF .\end{matrix}$ working output power of the cell, the incident light power, the maximum power point voltage of the cell, the maximum power point current of the cell, the open circuit voltage, and the short circuit current, respectively. 20

The results showed that an obvious degradation phenomenon occurred at the junction box after the aging test of the solar cell module prepared in Comparative example 1 in the 85°C/85% RH test box for about 100 h. At this moment, the photoelectric conversion efficiency decreased to 23% of the original efficiency. However, the solar cell module prepared in Embodiment 1 still kept black without an obvious change after the aging test in the 85°C/85% RH test box for 700 h. At this moment, the photoelectric conversion efficiency still remained 98% or above.

In conclusion, it should be noted that each of the above embodiments is for description of the technical solutions of the present application only, rather than for limiting the present application. Although the present application has been described in detail with reference to the above embodiments, persons of ordinary skill in the art should appreciate that they may still make modifications to the technical solutions described in the embodiments or make equivalent replacements to some or all technical features thereof without departing from the scope of the technical solutions of the embodiments of the present application. All such modifications and equivalent replacements shall fall within the scope of claims and specification of the present application. Especially, provided that there is no structural conflict, the various technical features mentioned in each embodiment may be combined in any way. The present application is not limited to the specific embodiments disclosed herein, but includes all technical solutions falling within the scope of the claims.

## Claims

1. A solar cell module, comprising:
a solar cell, electrically connected to busbars, each busbar having a lead-out end;
a backsheet, located on a back face of the solar cell, and provided with a lead hole corresponding to the lead-out ends; and
a waterproof layer, comprising a filling part and a connecting part connected to each other, the filling part filling an interior of the lead hole and sealing the lead hole, the lead-out ends extend out of the lead hole through the filling part, and the connecting part circumferentially surrounding the filling part and being held between the solar cell and the backsheet.

2. The solar cell module according to claim 1, wherein a water vapor transmission rate of the waterproof layer is less than 0.1 g/m²*d.

3. The solar cell module according to claim 1, wherein a water vapor transmission rate of the waterproof layer is 0.01 g/m²*d to 0.05 g/m²*d.

4. The solar cell module according to claim 2 or 3, wherein a material of the waterproof layer is at least one of rubber, silica gel, a silica gel mixture, organic silicon rubber, or a rubber mixture.

5. The solar cell module according to claim 2 or 3, wherein a material of the waterproof layer is butyl rubber.

6. The solar cell module according to any one of claims 1 to 5, wherein the waterproof layer is bonded between the solar cell and the backsheet.

7. The solar cell module according to any one of claims 1 to 6, wherein an area of the waterproof layer is smaller than an area of the backsheet.

8. The solar cell module according to claim 7, wherein a ratio of the area of the waterproof layer to the area of the backsheet is 1:20-1:100.

9. The solar cell module according to claim 7 or 8, wherein a junction box is disposed at a side of the backsheet facing away from the solar cell, the busbars are electrically connected to the junction box, and an orthographic projection of the waterproof layer on the backsheet is located in an orthographic projection of the junction box on the backsheet.

10. The solar cell module according to any one of claims 1 to 9, further comprising a backside encapsulant film located between the backsheet and the solar cell, wherein
the waterproof layer is located between the solar cell and the backside encapsulant film, and/or, the waterproof layer is located between the backsheet and the backside encapsulant film.

11. The solar cell module according to any one of claims 1 to 10, wherein the solar cell is a perovskite solar cell.

12. The solar cell module according to any one of claims 1 to 11, comprising a transparent panel located on a front side of the solar cell.

13. The solar cell module according to claim 12, further comprising a sealing element, wherein the sealing element circumferentially surrounds the solar cell, and is bonded to the transparent panel and the backsheet through lamination respectively to form a sealed space for accommodating the solar cell.

14. A photovoltaic module, comprising a plurality of electrically connected solar cell modules according to any one of claims 1 to 13.

15. An electric device, comprising the solar cell module according to any one of claims 1 to 13 or the photovoltaic module according to claim 14, the photovoltaic module being configured to provide electric energy for the electric device.
